# EUROPEAN PATENT APPLICATION

(11) **EP 2 374 766 A1**
(43) Date of publication of application: **12.10.2011**
(21) Application number: 09850254.5
(22) Date of filing: 09.10.2009
(51) Int. Cl.: C03C 17/32, B32B 17/06

(54) **PROCESS FOR PRODUCING FLEXIBLE GLASS SUBSTRATE, AND FLEXIBLE GLASS SUBSTRATE**

(71) Applicant: Micro Technology Co. Ltd., Tokyo 151-0063 (JP)
(72) Inventor: YOSHIKAWA Minoru, Tokyo 151-0063 (JP)
(74) Representative: Gulde Hengelhaupt Ziebig & Schneider
(86) International application number: PCT/JP2009/067625
(87) International publication number: WO 2011/042983

(57) **Abstract**

[Problem to be Solved]

A method for producing a flexible glass substrate which is approximately 100% impermeable to gas or vapor and excellent in bendability and a flexible glass substrate are provided.

[Solution]

After forming of a pattern P on a surface of a glass substrate 1, a support 3 is temporarily attached to the surface, the glass substrate 1 is thinned by etching another surface of the glass substrate 1, a film base 5 is laminated to the etched another surface, and the temporarily attached support 3 is peeled off from the one surface of the glass substrate 1.

## Description

### Technical Field

The present invention relates to a method for manufacturing a flexible glass substrate which is approximately 100% impermeable to gas or vapor and excellent in bendability, and a flexible glass substrate.

### Background Art

Recently, in the field of flat panel displays such as liquid crystal display devices and organic EL display devices, substituting a plastic film of a transparent polymer for a conventional glass substrate has been under study for improving a shatter resistance, reduction in weight, and reduction in thickness. Examples of such a film include a transparent conductive film for use in display composed of a polyethersulfone film having a small birefringence on which an indium oxide film is formed, which is described in Patent Literature 1.

A plastic film, however, has disadvantages such as a larger dimensional change caused by heat or moisture absorption and a lower impermeability to gas or vapor compared to glass.

As required by the circumstance, the present inventors invented a glass/film substrate composed of glass which is approximately 100% impermeable to gas or vapor laminated with a film (see Non Patent Literature 1). In the glass/film substrate, a glass and a film are laminated and the glass alone is thinned by etching to a thickness of 0.15 mm and thereby an unprecedented bendable glass substrate with a high barrier effect to gas or vapor and an excellent bendability was realized.

Since reducing a thickness of flat panel displays such as liquid crystal display devices and organic ELs or electronic papers is in a further progress, the present inventors also have further thinned the glass/film substrate described in the Non Patent Literature 1.

### Prior Art Document

### Patent Literature

Patent Literature 1: Japanese Patent Laid-Open No. 59-158015

Non Patent Literature 1: "Bendable Glass: Component for EL/Electronic Paper" [online] Jan. 2009, Micro Technology Co., Ltd. [searched on Oct. 7, 2009], Internet <URL: http://www.microtc.com/randd/index.html>

### Summary of Invention

### Problem to be solved by the invention

The present invention is aimed at improvement of the above-described glass/film substrate. An object of the invention is to provide a method for producing a flexible glass substrate which is drastically thinner than predecessors, approximately 100% impermeable to gas or vapor, excellent in flexibility for free and large bending, and to provide the flexible glass substrate.

### Means for solving problem

The present invention is a method for producing a flexible glass substrate in which a film base is laminated to a glass substrate for achieving the objects, comprising the steps of: temporarily attaching a support to a surface of a glass substrate; thinning the glass substrate by etching another surface of the glass substrate; laminating a film base to the etched another surface; and peeling off the temporarily attached support from the one surface of the glass substrate.

Also, the present invention is a method for producing a flexible glass substrate in which a film base is laminated to a glass substrate, comprising the steps of: temporarily attaching a support to one surface of the glass substrate after deposition treatment to the one surface; thinning the glass substrate by etching another surface of the glass substrate; laminating a film base to the etched another surface; and peeling off the temporarily attached support from the one surface of the glass substrate.

Also, the present invention is a method for producing a flexible glass substrate in which a film base is laminated to a glass substrate, comprising the steps of: temporarily attaching a support to one surface of the glass substrate after deposition treatment to the one surface; thinning the glass substrate by etching another surface of the glass substrate to a thickness of the glass substrate ranging from 2 µm to 30 µm; laminating a film base to the etched another surface; and peeling off the temporarily attached support from the one surface of the glass substrate.

Also, a flexible glass substrate according to the present invention is produced by: temporarily attaching a support to a surface of a glass substrate; thinning the glass substrate by etching another surface of the glass substrate; laminating a film base to the etched another surface; and peeling off the temporarily attached support from the one surface of the glass substrate.

Also, a flexible glass substrate according to the present invention is produced by: temporarily attaching a support to one surface of the glass substrate after deposition treatment to the one surface; thinning the glass substrate by etching another surface of the glass substrate; laminating a film base to the etched another surface; and peeling off the temporarily attached support from the one surface of the glass substrate.

Also, a flexible glass substrate according to the present invention is produced by: temporarily attaching a support to one surface of the glass substrate after deposition treatment to the one surface; thinning the glass substrate by etching another surface of the glass substrate to a thickness of the glass substrate ranging from 2 µm to 30 µm; laminating a film base to the etched another surface; and peeling off the temporarily attached support from the one surface of the glass substrate.

### Advantageous effects of Invention

In the present invention, a support is temporarily attached to a surface of a glass substrate, the glass substrate is thinned by etching another surface of the glass substrate, a film base is laminated to the etched another surface, and the temporarily attached support is peeled off from the one surface of the glass substrate. Consequently, provided is a flexible glass substrate which is approximately 100% impermeable to gas or vapor, drastically thinner than predecessors, and enhanced in bending property.

### Brief Description of Drawing

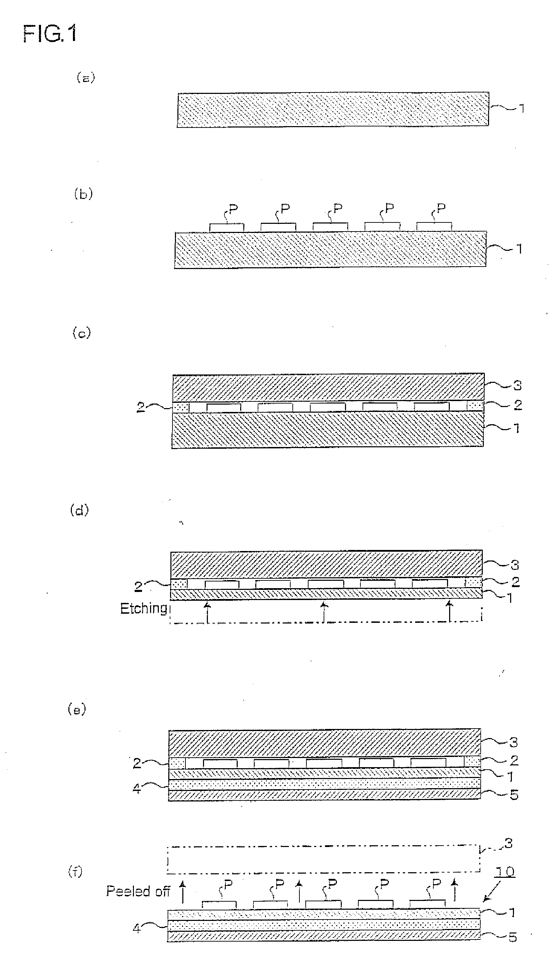

[Figure 1] Figure 1 illustrates a method for producing a flexible glass substrate according to the present invention.

### Mode for carrying out the claimed invention

The best mode for carrying out the invention will be explained in detail with reference to the attached drawings. Figure 1 illustrates a method for producing a flexible glass substrate according to the present invention. In Figure 1, although the etched glass substrate shown in (f) has a smaller thickness compared to the glass substrate shown in (a), the same reference numeral is used to designate the same part having a different thickness.

As shown in Figure 1 (f), a flexible glass substrate 10 of the present invention is an ultrathin glass substrate 1 in which a pattern P is formed on a glass substrate 1 and a film base 5 is laminated to the glass substrate 1 by an adhesive 4.

A flexible glass substrate 10 of the present invention is used for making thin displays such as liquid crystal displays, organic EL displays, plasma panel displays, and electronic papers.

The pattern P can be formed on the glass substrate 1 by various existing methods. Examples of the methods include deposition of indium tin compound oxide (ITO) through a dry process such as vacuum vapor deposition or sputtering.

Material used for the film base 5 in the present invention is not specifically limited. For example, polycarbonate, polyethylene terephthalate, polyethylene naphthalate, polyether sulfone, polyimide, an epoxy resin, a phenol resin, a melamine resin, polyurethane, polyurea, polyethylene, polypropylene, a nylon resin, polyvinyl chloride, an acrylic resin, polystyrene, an acrylonitrile butadiene styrene resin, an acrylonitrile styrene resin, or polyvinylidene chloride may be used.

The thickness of the film base 5 used in the present invention is not specifically limited. A thickness of not larger than 500 µm is preferred for enhancing flexibility. A thickness of not smaller than 1 µm is preferred for securing strength. A thickness of not smaller than 25 µm is preferred for ease of handling.

A method for producing a flexible glass substrate 10 will be explained below in detail with reference to Figure 1.

First, as shown in Figure 1 (a), a glass substrate 1 is prepared. Although the thickness of the glass substrate 1 is not specifically limited, a preferred thickness ranges from 0.2 mm to 0.7 mm considering workability. A size of the unprocessed glass substrate 1 is appropriately determined considering ease of handling relative to a sheet thickness. For example, a 300 mm square or a 400 mm square for a sheet thickness of 0.2 mm and a 1 m square for a sheet thickness of 0.7 mm may be used.

Subsequently, after deposition treatment is carried out to a surface of the glass substrate 1 (i.e. the upper surface in Figure 1 (b)) by CVD, sputtering, deposition, or plating, a pattern P is formed by photo-etching or printing. In the present invention, since the pattern can be formed on a glass substrate 1 having a large sheet thickness, a large size of the substrate can be used. In addition, in a process at a high temperature ranging from 150°C to 350°C required for the pattern configuration, a plastic film has a problem with heat resistance. On the contrary, the present invention has no problem with heat resistance, since the pattern is formed on the glass substrate 1 prior to the lamination of the film base 5.

Subsequently, as shown in Figure 1 (c), a support 3 is temporarily attached through an adhesive 2 to the one surface of the glass substrate 1 having the pattern P formed thereon. Although a glass sheet or a resin sheet is available for the support 3, an elastic film material may also be used. The adhesive 2 is applied to a peripheral portion of the glass substrate 1 in order to readily peel off the support 3 later. An acid-resisting adhesive is used for the adhesive 2 to prevent invasion by an etching solution into a space between the glass substrate 1 and the support 3 during the etching.

Subsequently, as shown in Figure 1 (d), another surface of the glass substrate 1 (i.e. the lower surface in Figure 1 (d)) is thinned through etching using hydrofluoric acid. In the present invention, the glass substrate 1 is thinned to a sheet thickness ranging from 2 µm to 30 µm. In the present invention, since the glass 2 µm to 30 µm. In the present invention, since the glass substrate 1 can be etched in a state having the support 3, a drastically thinner substrate can be achieved compared to a glass/film substrate described in the Non Patent Literature 1.

After the glass substrate 1 is thinned to a desired thickness by the etching, as shown in Figure 1 (e), a film base 5 is laminated to another surface of the glass substrate 1 (i.e. the lower surface in Figure 1 (e)) by an adhesive 4. A heat-resisting acrylic adhesive is used for the adhesive 4.

Subsequently, as shown in Figure 1 (f), the support 3 temporarily attached to a surface of the glass substrate 1 is peeled off from the glass substrate 1. Consequently, a flexible glass substrate 10 of the present invention is made. A method such as softening treatment by heat, photolytic degradation, or peeling by a blade may be used for peeling off.

As described above, the flexible glass substrate of the present invention is produced by: temporarily attaching a support to one surface of the glass substrate after deposition treatment to the one surface; thinning the glass substrate by etching another surface of the glass substrate; laminating a film base to the etched another surface; and peeling off the temporarily attached support from the one surface of the glass substrate. Thereby an approximately 100% impermeability to gas or vapor is achieved with an unprecedented drastically thinner thickness, and an enhanced bending property. That is, a passivation effect can be achieved without impairing flexing properties of a film.

The flexible glass substrate of the present invention may be used not only for a field such as flat panel displays or electronic papers but also for a wider field such as electronics, electric apparatus, cells, or optical elements as an alternative to a film. Although the glass substrate in the embodiment described above has a formed pattern, a glass substrate with deposition treatment alone or having an unprocessed surface may be also used as a flexible glass substrate of the present invention.

### Reference Signs List

- 1: Glass substrate
- 2: Adhesive
- 3: Support
- 4: Adhesive
- 5: Film base
- 10: Flexible glass substrate
- P: Pattern

## Claims

1. A method for producing a flexible glass substrate in which a film base is laminated to a glass substrate, comprising the steps of:
temporarily attaching a support to one surface of the glass;
thinning the glass substrate by etching another surface of the glass substrate;
laminating the film base to the etched another surface; and
peeling off the temporarily attached support from the one surface of the glass substrate.

2. A method for producing a flexible glass substrate in which a film base is laminated to a glass substrate, comprising the steps of:
temporarily attaching a support to one surface of the glass substrate after deposition treatment to the one surface;
thinning the glass substrate by etching another surface of the glass substrate;
laminating the film base to the etched another surface; and
peeling off the temporarily attached support from the one surface of the glass substrate.

3. A method of making a flexible glass substrate in which a film base is laminated to a glass substrate, comprising the steps of:
temporarily attaching a support to one surface of the glass substrate after deposition treatment to the one surface;
thinning the glass substrate by etching another surface of the glass substrate to a thickness of the glass substrate ranging from 2 µm to 30 µm;
laminating the film base to the etched another surface; and
peeling off the temporarily attached support from the one surface of the glass substrate.

4. A method of making a flexible glass substrate, comprising:
temporarily attaching a support to one surface of the glass substrate;
thinning the glass substrate by etching another surface of the glass substrate;
laminating the film base to the etched another surface;
peeling off the temporarily attached support from the one surface of the glass substrate.

5. A flexible glass substrate produced by:
temporarily attaching a support to one surface of the glass substrate after deposition treatment to the one surface;
thinning the glass substrate by etching another surface of the glass substrate;
laminating a film base to the etched another surface; and
peeling off the temporarily attached support from the one surface of the glass substrate.

6. A flexible glass substrate produced by:
temporarily attaching a support to one surface of the glass substrate after deposition treatment to the one surface;
thinning the glass substrate by etching another surface of the glass substrate to a thickness of the glass substrate ranging from 2 µm to 30 µm;
laminating a film base to the etched another surface; and
peeling off the temporarily attached support from the one surface of the glass substrate.

## Amended claims

### Amended claims under Art. 19.1 PCT

**1.** A method for producing a flexible glass substrate in which a film base is laminated to a glass substrate, comprising the steps of:
temporarily attaching a support to one surface of the glass substrate after deposition treatment to the one surface;
thinning the glass substrate by etching another surface of the glass substrate;
laminating the film base to the etched another surface; and
peeling off the temporarily attached support from the one surface of the glass substrate.

**2.** A method of making a flexible glass substrate in which a film base is laminated to a glass substrate, comprising the steps of:
temporarily attaching a support to one surface of the glass substrate after deposition treatment to the one surface;
thinning the glass substrate by etching another surface of the glass substrate to a thickness of the glass substrate ranging from 2 µm to 30 µm;
laminating the film base to the etched another surface; and
peeling off the temporarily attached support from the one surface of the glass substrate.

**3.** A flexible glass substrate produced by:
temporarily attaching a support to one surface of the glass substrate after deposition treatment to the one surface;
thinning the glass substrate by etching another surface of the glass substrate;
laminating a film base to the etched another surface; and
peeling off the temporarily attached support from the one surface of the glass substrate.

**4.** A flexible glass substrate produced by:
temporarily attaching a support to one surface of the glass substrate after deposition treatment to the one surface;
thinning the glass substrate by etching another surface of the glass substrate to a thickness of the glass substrate ranging from 2 µm to 30 µm;
laminating a film base to the etched another surface; and
peeling off the temporarily attached support from the one surface of the glass substrate.

**5.** A method for producing a flexible glass substrate in which a film base is laminated to a glass substrate, comprising the steps of:
forming a pattern on one surface of the glass substrate after deposition treatment to the one surface and temporarily attaching a support to the one surface of the glass substrate;
thinning the glass substrate by etching another surface of the glass substrate;
laminating the film base to the etched another surface; and
peeling off the temporarily attached support from the one surface of the glass substrate.

**6.** A flexible glass substrate produced by:
forming a pattern on one surface of the glass substrate after deposition treatment to the one surface and temporarily attaching a support to the one surface of the glass substrate;
thinning the glass substrate by etching another surface of the glass substrate;
laminating a film base to the etched another surface; and
peeling off the temporarily attached support from the one surface of the glass substrate.
